(19)

Europäisches
Patentamt
European
Patent Office
Office européen
des brevets

(11) **EP 4 749 307 A1**

(12) **EUROPEAN PATENT APPLICATION**
published in accordance with Art. 153(4) EPC

(43) Date of publication:
**27.05.2026 Bulletin 2026/22**

(21) Application number: **24865717.3**

(22) Date of filing: **23.08.2024**

(51) International Patent Classification (IPC):
**G01R 31/392** (2019.01)  **G01R 31/385** (2019.01)
**G01R 31/367** (2019.01)  **G01R 19/10** (2006.01)
**G01R 19/00** (2006.01)

(52) Cooperative Patent Classification (CPC):
**G01R 19/00; G01R 19/10; G01R 31/367;**
**G01R 31/385; G01R 31/392;** Y02E 60/10

(86) International application number:
**PCT/KR2024/012584**

(87) International publication number:
**WO 2025/058276 (20.03.2025 Gazette 2025/12)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **14.09.2023 KR 20230122554**

(71) Applicant: **LG Energy Solution, Ltd.**
**Seoul 07335 (KR)**

(72) Inventor: **CHOI, Jung Hwan**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **BATTERY DIAGNOSIS APPARATUS AND OPERATION METHOD THEREOF**

(57) A battery diagnosis apparatus according to an embodiment disclosed herein includes a sensor configured to obtain a voltage value of each of battery cells and a processor configured to calculate a cell voltage deviation of each of the battery cells based on the voltage value and an average voltage value of the battery cells, calculate a moving average of the cell voltage deviation based on the cell voltage deviation, calculate a low-voltage period based on the moving average, and diagnose whether the battery cells are abnormal, based on the moving average and the low-voltage period.

FIG.1

EP 4 749 307 A1

# EP 4 749 307 A1

**Description**

## TECHNICAL FIELD

<u>CROSS-REFERENCE TO RELATED APPLICATION</u>

This application claims priority to and the benefit of Korean Patent Application No. 10-2023-0122554 filed in the Korean Intellectual Property Office on September 14, 2023, the entire content of which is incorporated herein by reference.

<u>TECHNICAL FIELD</u>

Embodiments disclosed herein relate to a battery diagnosis apparatus and an operating method thereof.

## BACKGROUND ART

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

As industrial fields using batteries expand, battery management systems (BMSs) diagnosing safety of batteries are also developing. The BMS may diagnose performance of a battery by using various diagnosis algorithms, and perform appropriate control according to a state of the battery. Generally, a battery pack includes a plurality of battery cells, and the BMS may detect an abnormal cell with excessively low capacity among the plurality of battery cells.

## DISCLOSURE

## TECHNICAL PROBLEM

Generally, a BMS may detect an abnormal battery cell by using a voltage drop rate according to a unit time, based on a voltage value of each of battery cells.

However, for an abnormal battery cell having a small internal short-circuit among abnormal battery cells, a voltage value slowly drops for a long time, such that the BMS may misdiagnose the battery cell as a normal battery cell. Thus, the accuracy of detection of an abnormal battery cell is degraded.

Technical problems of the embodiments disclosed herein are not limited to the above-described technical problems, and other unmentioned technical problems would be clearly understood by one of ordinary skill in the art from the following description.

## TECHNICAL SOLUTION

A battery diagnosis apparatus according to an embodiment disclosed herein includes a sensor configured to obtain a voltage value of each of battery cells and a processor configured to calculate a cell voltage deviation of each of the battery cells based on the voltage value and an average voltage value of the battery cells, calculate a moving average of the cell voltage deviation based on the cell voltage deviation, calculate a low-voltage period based on the moving average, and diagnose whether the battery cells are abnormal, based on the moving average and the low-voltage period.

In an embodiment, the cell voltage deviation may include a first cell voltage deviation that is a cell voltage deviation at a current time point and a second cell voltage deviation that is a cell voltage deviation at a previous time point, and the moving average may include a first moving average that is a moving average of the cell voltage deviation at the current time point and a second moving average that is a moving average of the cell voltage deviation at the previous time point.

In an embodiment, the processor may be further configured to calculate the first moving average based on the first cell voltage deviation and the second moving average.

In an embodiment, the processor may be further configured to calculate a moving average variance based on a difference between the first moving average and the second moving average, calculate a time variance between a time point corresponding to the first cell voltage deviation and a time point corresponding to the second cell voltage deviation, and calculate the low-voltage period based on the moving average variance and the time variance.

In an embodiment, the processor may be further configured to calculate the low-voltage period based on a result of comparison between the moving average variance and a reference value.

In an embodiment, the low-voltage period may include a first low-voltage period that is the low-voltage period at the current time point and a second low-voltage period that is the low-voltage period at the previous time point.

In an embodiment, the processor may be further configured to calculate the first low-voltage period by adding the time variance to the second low-voltage period when the moving average variance is greater than or equal to the reference value.

In an embodiment, the processor may be further configured to calculate the first low-voltage period by subtracting the time variance from the second low-voltage period when the moving average variance is less than the reference value.

In an embodiment, the processor may be further configured to calculate a threshold range based on the moving average and the low-voltage period and diagnose, as an abnormal battery cell, a battery cell in which the low-voltage period with respect to the moving average falls within the threshold range.

In an embodiment, the average voltage value may be an average of voltage values for each battery module including the battery cells.

An operating method of a battery diagnosis apparatus according to an embodiment disclosed herein includes obtaining a voltage value of each of battery cells, calculating a cell voltage deviation of each of the battery cells based on the voltage value and an average voltage value of the battery cells, calculating a moving average of the cell voltage deviation based on the cell voltage deviation, calculating a low-voltage period based on the moving average, and diagnosing whether the battery cells are abnormal, based on the moving average and the low-voltage period.

In an embodiment, the cell voltage deviation may include a first cell voltage deviation that is a cell voltage deviation at a current time point and a second cell voltage deviation that is a cell voltage deviation at a previous time point, and the moving average may include a first moving average that is a moving average of the cell voltage deviation at the current time point and a second moving average that is a moving average of the cell voltage deviation at the previous time point.

In an embodiment, the calculating of the moving average may include calculating the first moving average based on the first cell voltage deviation and the second moving average.

In an embodiment, the calculating of the low-voltage period may include calculating a moving average variance based on a difference between the first moving average and the second moving average, calculating a time variance between a time point corresponding to the first cell voltage deviation and a time point corresponding to the second cell voltage deviation, and calculating the low-voltage period based on the moving average variance and the time variance.

In an embodiment, the calculating of the low-voltage period may include calculating the low-voltage period based on a result of comparison between the moving average variance and a reference value.

In an embodiment, the low-voltage period may include a first low-voltage period that is the low-voltage period at the current time point and a second low-voltage period that is the low-voltage period at the previous time point.

In an embodiment, the calculating of the low-voltage period may include calculating the first low-voltage period by adding the time variance to the second low-voltage period when the moving average variance is greater than or equal to the reference value.

In an embodiment, the calculating of the low-voltage period may include calculating the first low-voltage period by subtracting the time variance from the second low-voltage period when the moving average variance is less than the reference value.

In an embodiment, the diagnosing may include calculating a threshold range based on the moving average and the low-voltage period and diagnosing, as an abnormal battery cell, a battery cell in which the low-voltage period with respect to the moving average falls within the threshold range.

In an embodiment, the average voltage value may be an average of voltage values for each battery module including the battery cells.

## ADVANTAGEOUS EFFECTS

A battery diagnosis apparatus and an operating method thereof according to various embodiments disclosed herein may detect an abnormal battery cell having a voltage value slowly dropping over a long time based on various parameters calculated based on a voltage value of each of battery cells.

The technical effects of the battery diagnosis apparatus and the operating method thereof according to embodiments disclosed in the present document are not limited to the effects mentioned above, and other effects not mentioned will be clearly understood by those of ordinary skill in the art according to the disclosure of the present document.

## DESCRIPTION OF DRAWINGS

FIG. 1 shows a battery pack according to an embodiment disclosed herein.

FIG. 2 is a block diagram of a battery diagnosis apparatus, according to an embodiment disclosed herein.

FIG. 3 shows a battery diagnosis apparatus for diagnosing a battery pack outside a battery pack, according to an embodiment disclosed herein.

FIG. 4 is a graph for SOC-OCV according to an embodiment disclosed herein.

FIG. 5 shows a cell voltage deviation of each of battery cells, according to an embodiment disclosed herein.

FIG. 6 shows a moving average of a cell voltage deviation according to an embodiment disclosed herein.

FIG. 7 is a graph of a time-moving average and a time-low-voltage period, according to an embodiment disclosed herein.

FIG. 8 shows a threshold range based on a moving average and a low-voltage period, according to an embodiment disclosed herein.

FIG. 9 is a flowchart showing an operating method of a battery diagnosis apparatus according to an embodiment disclosed herein.

FIG. 10 is a flowchart showing a detailed operating method of operation 906 according to an embodiment disclosed herein.

FIG. 11 is a flowchart showing a detailed operating method of operation 908 according to an embodiment disclosed herein.

With regard to the description of the drawings, identical reference numerals may be used to refer to identical or related elements.

## MODE FOR INVENTION

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. In the case of online distribution, at least a part of a computer program product may be at least temporarily stored in a machine-readable storage medium such as a memory of a server of a manufacturer, a server of an application store, or a relay server, or may be generated temporarily.

According to embodiments disclosed herein, each of the above-described components (e.g., a module or program) may include a single entity or a plurality of entities, some of which may be separately disposed on other components. According to embodiments disclosed herein, one or more of the above-described components or operations may be omitted, or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to embodiments disclosed herein, operations performed by a module, a program, or other components may be executed sequentially, in parallel, repeatedly, or heuristically, or one or more of the operations may be executed in a different order or omitted, or one or more other operations may be added.

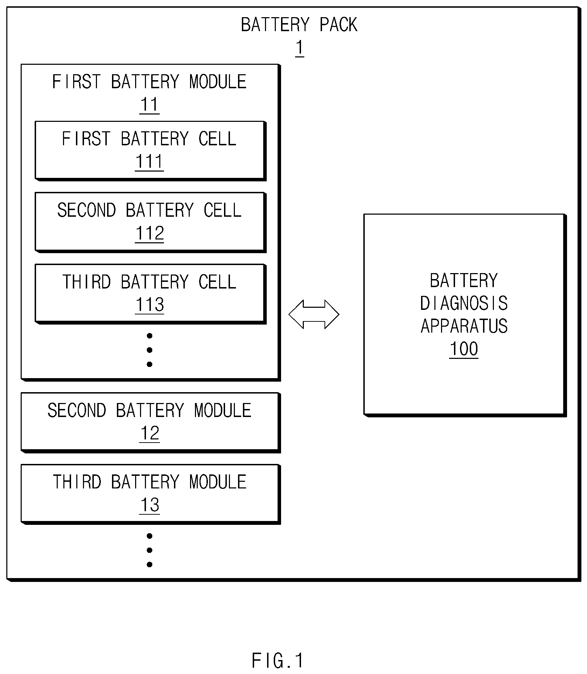

FIG. 1 illustrates a battery pack according to an embodiment disclosed herein.

Referring to FIG. 1, a battery pack 1 may include a plurality of battery modules 11, 12, ..., 13, and a battery diagnosis apparatus 100. The first battery module 11 may include a plurality of battery cells 111, 112, and 113. While only the battery cells 111, 112, and 113 included in the first battery module 11 are shown in FIG. 1, the second battery module 12 and the third battery module 13 may also include a plurality of battery cells. Although only the battery cells 111, 112, and 113 included in the first battery module 11 will be described below, a description is equally applicable to a plurality of battery cells included in the second battery module 12 and the third battery module 13.

The battery diagnosis apparatus 100 may obtain a voltage value of each of the battery cells 111, 112, and 113. The battery diagnosis apparatus 100 may obtain a voltage value of each of the battery cells 111, 112, and 113 in a designated state of charge (SOC) section. Herein, the voltage value may be an open circuit voltage (OCV), and the following description will be made assuming that the voltage value is an OCV.

The battery diagnosis apparatus 100 may calculate a cell voltage deviation of each of the battery cells 111, 112, and 113. The battery diagnosis apparatus 100 may calculate a cell voltage deviation of each of the battery cells 111, 112, and 113 based on the voltage value of each of the battery cells 111, 112, and 113 and an average voltage value of the battery cells 111, 112, and 113. Herein, the cell voltage deviation may be a value obtained by subtracting an average voltage value of all or some of the battery cells 111, 112, and 113 from the voltage value of each of the battery cells 111, 112, and 113. The cell voltage deviation may include a first cell voltage deviation that is a cell voltage deviation at the current time point and a second cell voltage deviation that is a cell voltage deviation at a previous time point.

In an embodiment, the battery diagnosis apparatus 100 may calculate a cell voltage deviation for each battery module. The battery diagnosis apparatus 100 may calculate the cell voltage deviation of each of the battery cells 111, 112, and 113 based on an average voltage value of the first battery module 11. Likewise, the battery diagnosis apparatus 100 may calculate a cell voltage deviation of each of battery cells included in the second battery module 12 based on an average voltage value of the battery cells included in the second battery module 12.

The battery diagnosis apparatus 100 may calculate a moving average of the cell voltage deviation based on the cell voltage deviation. Herein, the moving average of the cell voltage deviation may be calculated based on cell voltage deviations in at least two time points. The moving average may include a first moving average that is a moving average at the current time point and a second moving average that is a moving average at the previous time point.

The battery diagnosis apparatus 100 may calculate a low-voltage period based on the moving average of the cell voltage deviation. Herein, the low-voltage period may be a period in which an internal short-circuit of a battery cell occurs and thus a moving average of a cell voltage deviation is less than a designated threshold value. The low-voltage period may include a first low-voltage period that is a low-voltage period at the current point in time and a second low-voltage period that is a low-voltage period at the previous time point.

The battery diagnosis apparatus 100 may diagnose whether the battery cells 111, 112, and 113 are abnormal, based on the moving average and the low-voltage period.

In an embodiment, the battery diagnosis apparatus 100 may be included in a battery management system (BMS) capable of diagnosing the battery pack 1, and operations performed in the battery diagnosis apparatus 100 may be performed in the BMS. The following operation of the battery diagnosis apparatus 100 may also be performed in various devices such as not only a BMS in a vehicle, but also a server, a cloud, a charger, a charger/discharger, etc.

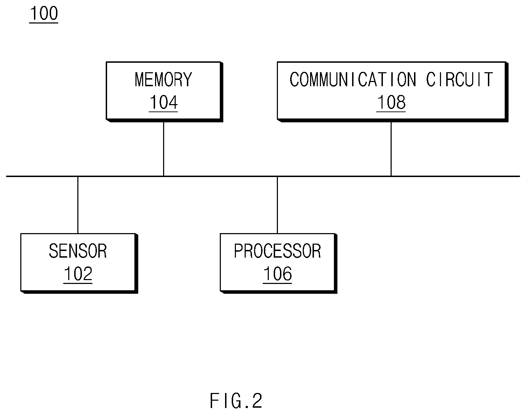

FIG. 2 is a block diagram of a battery diagnosis apparatus, according to an embodiment disclosed herein.

Referring to FIG. 2, the battery diagnosis apparatus 100 may include a sensor 102, a memory 104, a processor 106, and a communication circuit 108. According to an embodiment, the battery diagnosis apparatus 100 shown in FIG. 2 may further include at least one component (e.g., a display, an input device, or an output device) in addition to components shown in FIG. 2.

The sensor 102 may obtain values related to states of the battery cells 111, 112, and 113. In an embodiment, the values related to the states may indicate one or more values of voltages, currents, resistances, SOC, states of health (SOH), or temperatures of the battery cells 111, 112, and 113 or combinations thereof. Hereinbelow, the value related to the state may be referred to as a 'state value'.

In an embodiment, the sensor 102 may obtain a voltage value of each of the battery cells 111, 112, and 113 for a designated time or according to a designated period.

In an embodiment, the sensor 102 may not be included in the battery diagnosis apparatus 100 when the operations performed in the battery diagnosis apparatus 100 are implemented in a server, a cloud charger, or a charger/discharger.

The memory 104 may include a volatile and/or a nonvolatile memory.

In an embodiment, the memory 104 may include one or more software.

In an embodiment, the memory 104 may store data used by at least one component (e.g., the processor 106) of the battery diagnosis apparatus 100. For example, the data may include software (or an instruction related thereto), input data, or output data. In an embodiment, the instruction, when executed by the processor 106, may cause the battery diagnosis apparatus 100 to perform operations defined by the instruction.

The processor 106 may calculate a cell voltage deviation of each of the battery cells 111, 112, and 113. The processor 106 may calculate the cell voltage deviation of each of the battery cells 111, 112, and 113 based on the voltage value of each of the battery cells 111, 112, and 113 and the average voltage value of the battery cells 111, 112, and 113. Herein, the cell voltage deviation may be calculated based on the voltage value of each of the battery cells 111, 112, and 113 and the average voltage value of the voltage values of the battery cells 111, 112, and 113. The cell voltage deviation may include a first cell voltage deviation that is a cell voltage deviation at the current time point and a second cell voltage deviation that is a cell voltage deviation at a previous time point.

In an embodiment, the processor 106 may calculate a cell voltage deviation of each of all the battery cells included in the battery pack 1. For example, the processor 106 may calculate the cell voltage deviation of each of all the battery cells based on a difference between the voltage value of each of all the battery cells and an average voltage value of all the battery cells.

In an embodiment, the processor 106 may calculate a cell voltage deviation for each battery module. The processor 106 may calculate the cell voltage deviation of each of the battery cells 111, 112, and 113 based on a difference between the voltage value of each of the battery cells 111, 112, and 113 included in the first battery module 11 and an average voltage value of the battery cells 111, 112, and 113.

The processor 106 may calculate the moving average of the cell voltage deviation. The processor 106 may calculate the first moving average at the current time point based on the first cell voltage deviation that is the cell voltage deviation at the current time point and the second moving average calculated at the previous time point. Herein, the current time point, which is a term for distinguishment from the previous time point, may indicate not only the present based on real time, but also a specific time point previous to the present based on real time. The processor 106 may calculate the first moving average by using a weighted moving average. The processor 106 may calculate the first moving average based on a product of a designated weight value and each of the first cell voltage deviation and the second moving average. The first moving average may be given by Equation 1.

First Moving Average = Second Moving Average * (1 - Weight Value) + First Cell Voltage Deviation * Weight Value                                                                        [Equation 1]

Herein, the weight value may be a random value in a range of 0 and 1.

The processor 106 may calculate the low-voltage period based on the moving average. Herein, the low-voltage period may include a first low-voltage period at the current point in time and a second low-voltage period at the previous time point.

The processor 106 may calculate the first low-voltage period based on a variance of the moving average and a time variance. Herein, the variance of the moving average may be calculated based on the first moving average and the second moving average. The time variance may be calculated based on a difference between the current time point and the previous time point. The time variance may be calculated based on a difference between a time point corresponding to the first cell voltage deviation and a time point corresponding to the second cell voltage deviation.

The processor 106 may calculate a moving average variance based on the first moving average and the second moving average. Herein, the moving average variance may be calculated based on a difference between the first moving average calculated at the current time point and the second moving average calculated at the previous time point.

The processor 106 may calculate the low-voltage period based on a result of comparison between the moving average variance and a reference value. In an embodiment, the processor 106 may calculate the first low-voltage period at the current time point by adding the time variance to the second low-voltage period calculated at the previous time point when the moving average variance is greater than or equal to the reference value. The processor 106 may calculate the first low-voltage period at the current time point by subtracting the time variance from the second low-voltage period calculated at the previous time point when the moving average variance is less than the reference value.

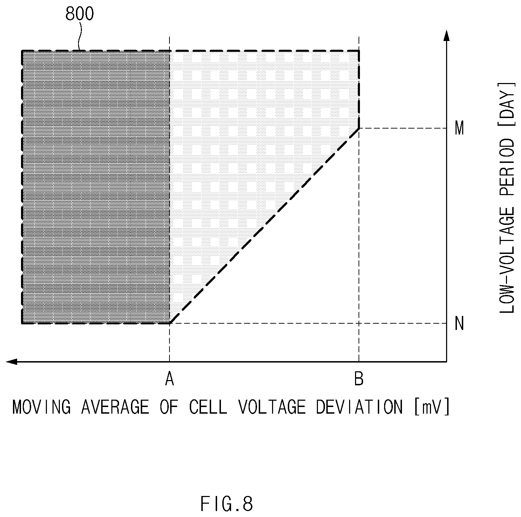

The processor 106 may diagnose whether the battery cells 111, 112, and 113 are abnormal, based on the moving average and the low-voltage period. In an embodiment, the processor 106 may calculate a threshold range based on the moving average and the low-voltage period. Herein, the threshold range may be coordinates corresponding to the low-voltage period according to the moving average. A detailed description regarding the threshold range will be made below with reference to FIG. 8.

The processor 106 may diagnose, as an abnormal battery cell, a battery cell in which a low-voltage period corresponding to a moving average falls within the threshold range. The processor 106 may diagnose, as an abnormal battery cell, a battery cell in which the first low-voltage period corresponding to the first moving average falls within the threshold range.

In an embodiment, the processor 106 may include a central processing unit, an application processor, a graphic processing unit, a neural processing unit (NPU), an image signal processor, a sensor hub processor, or a communication processor.

In an embodiment, the processor 106 may execute software to control at least one other component (e.g., a hardware or software component) of the battery diagnosis apparatus 100 connected to the processor 106 and may process or compute various data.

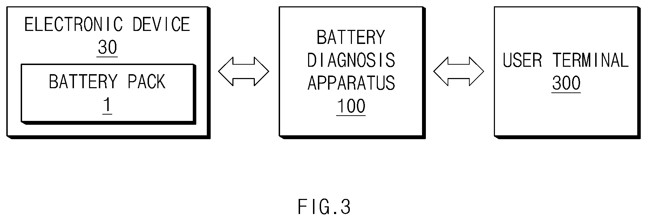

The communication circuit 108 may transmit a diagnosis result to the user terminal. Herein, the user terminal may be a device that controls the battery diagnosis apparatus 100 and/or receives a diagnosis result from the battery diagnosis apparatus 100. The user terminal will be described below with reference to FIG. 3.

In an embodiment, the communication circuit 108 may establish a wired communication channel and/or a wireless communication channel between the battery diagnosis apparatus 100 and an electronic device including the battery pack 1, and transmit and receive data to and from the electronic device through the established communication channel. The electronic device including the battery pack 1 will be described later with reference to FIG. 3.

In an embodiment, the communication circuit 108 of the battery diagnosis apparatus 100 may establish a wired communication channel and/or a wireless communication channel between the battery diagnosis apparatus 100 and the user terminal and/or the electronic device, and transmit and receive data to and from the user terminal and/or the electronic device through the established communication channel.

FIG. 3 shows a battery diagnosis apparatus for diagnosing a battery pack outside a battery pack, according to an embodiment disclosed herein.

Referring to FIG. 3, the battery diagnosis apparatus 100 may be wiredly/wirelessly connected to an electronic device 30 and/or a user terminal 300. Herein, the electronic device 30 may be a mobile device (e.g., a mobile phone, a laptop computer, a smart phone, a smart pad), an electric vehicle (e.g., an electric vehicle (EV), a hybrid EV (HEV), a plug-in HEV (PHEV), a fuel cell EV (FCEV)), or an energy storage system (ESS). The user terminal 300 may be a device that controls the battery diagnosis apparatus 100 or receives the diagnosis result from the battery diagnosis apparatus 100 and may be a mobile device (e.g., a mobile phone, a laptop computer, a smart phone, a smart pad) or a personal computer (PC). In an embodiment, the connection between the battery diagnosis apparatus 100 and the electronic device 30 and/or the user terminal 300 may be communication connection through a wired and/or wireless network.

The battery diagnosis apparatus 100 may obtain voltage values of the battery cells 111, 112, and 113. The battery diagnosis apparatus 100 may obtain voltage values of the battery cells 111, 112, and 113 through a wired/wireless network. In this case, the battery diagnosis apparatus 100 may not include the sensor 102 and may obtain the voltage values of the battery cells 111, 112, and 113 through the communication circuit 108.

The battery diagnosis apparatus 100 may transmit a diagnosis result of diagnosing whether the battery cells 111, 112, and 113 are abnormal to the user terminal 300. The battery diagnosis apparatus 100 may transmit the diagnosis result of diagnosing whether the battery cells 111, 112, and 113 are abnormal to the user terminal 300 through the communication circuit 108 via the established wired and/or wireless communication channel. Herein, the diagnosis result may include whether an abnormal battery cell is present, a state value of an abnormal battery cell, and/or a diagnosis result of a battery module including an abnormal battery cell, etc.

In an embodiment, the connection between the battery diagnosis apparatus 100 and the electronic device 30 and/or the user terminal 300 may be communication connection through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4th-Generation (4G) network, a 5th-Generation (5G) network).

In an embodiment, the connection between the battery diagnosis apparatus 100 and the electronic device 30 and/or the user terminal 300 may be connection using a device-to-device communication scheme (e.g., a bus, a general-purpose input and output (GPIO), a serial peripheral interface (SPI), or a mobile industry processor interface (MIPI)).

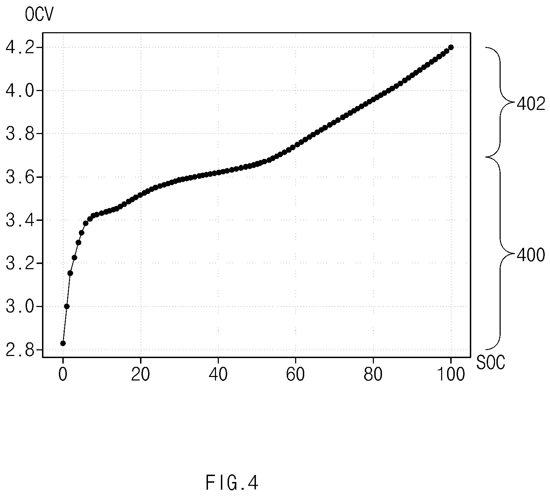

FIG. 4 is a graph for SOC-OCV according to an embodiment disclosed herein.

Referring to FIG. 4, the graph may include an OCV value with respect to an SOC of the battery pack 1.

Referring to the graph, in a second section 402 corresponding to a relatively high SOC, a voltage value with respect to an SOC rises similarly to a straight line without a sudden change in comparison to the first section 400. In a section including an inflection point or a section showing a rapid rise in an OCV, a cause for an error such as a difference between a charging OCV value and a discharging OCV value may occur. Thus, the battery diagnosis apparatus 100 may generate a more accurate diagnosis result when calculating a cell voltage deviation by using a voltage value obtained in the second section 402 in which a voltage value rises linearly without a sudden change.

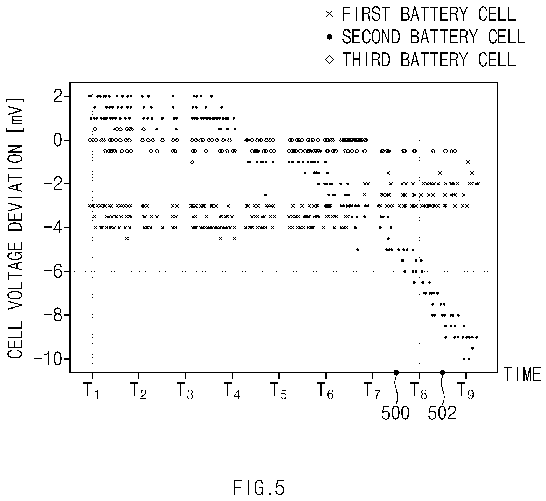

FIG. 5 shows a cell voltage deviation of each of battery cells, according to an embodiment disclosed herein.

Referring to FIG. 5, the graph may include a cell voltage deviation with respect to a time for each of the battery cells 111, 112, and 113. Herein, T1 to T9 are time units and may refer to time points evenly divided from several hours to several months.

The battery diagnosis apparatus 100 may calculate a cell voltage deviation based on a voltage value obtained every designated time points or every designated intervals.

The battery diagnosis apparatus 100 may calculate a moving average of the cell voltage deviation based on the calculated cell voltage deviations. For example, the battery diagnosis apparatus 100 may calculate a moving average of the cell voltage deviation moving average at a time point t2 502 based on cell voltage deviations of the first battery cell 111, calculated at a time point t1 500 and the time point t2 502.

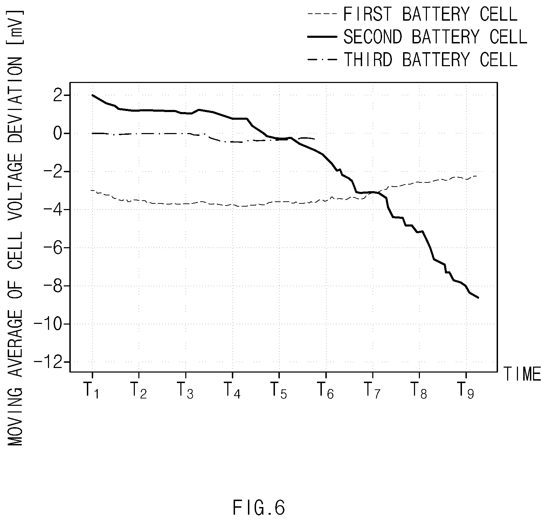

FIG. 6 shows a moving average of a cell voltage deviation according to an embodiment disclosed herein.

Referring to FIG. 6, the graph may include a moving average of a cell voltage deviation with respect to a time for each of the battery cells 111, 112, and 113. The battery diagnosis apparatus 100 may calculate a moving average of a cell voltage deviation based on cell voltage deviations of at least two time points (e.g., the time point t1 500 and the time point t2 502 of FIG. 5). For example, the battery diagnosis apparatus 100 may calculate a first moving average corresponding to the time point t2 502 by using Equation 1 based on the second moving average based on the second cell voltage deviation calculated at the previous time point t1 500 and the first cell voltage deviation calculated at the time point t2 500, for each of the first battery cell 111 to the third battery cell 113.

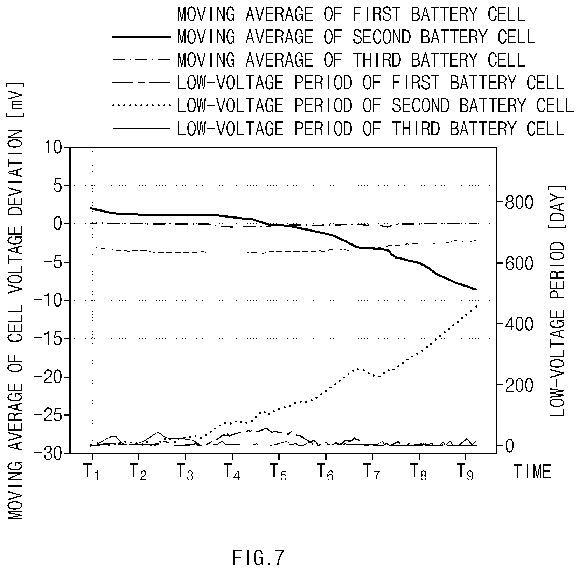

FIG. 7 is a graph of a time-moving average and a time-low-voltage period, according to an embodiment disclosed herein.

Referring to FIG. 7, the graph may include a moving average of a cell voltage deviation and a low-voltage period for each of the battery cells 111, 112, and 113.

Referring to the graph, a tendency of the moving average and the low-voltage period of the second battery cell 112 may be such that unlike the first battery cell 111 and the third battery cell 113, the moving average drops and at the same time, the low-voltage period rises. The battery diagnosis apparatus 100 may diagnose the second battery cell 112 as an abnormal battery cell when each of the first moving average at the current time point and the first low-voltage period at the current time point for the second battery cell 112 deviates from a threshold value. Herein, the first moving average and the first low-voltage period may refer to the most recently calculated values.

FIG. 8 shows a threshold range based on a moving average and a low-voltage period, according to an embodiment disclosed herein.

Referring to FIG. 8, the graph may include a threshold range 800. The threshold range 800 may be calculated based on a threshold value for each of the moving average and the low-voltage period. The threshold range 800 may be set considering at the same time, the moving averages and the low-voltage periods calculated at the current time point and the at the previous time point.

Referring to the graph, a battery cell having a first moving average less than or equal to A may be diagnosed as an abnormal battery cell regardless of the first low-voltage period. Herein, A and B may be less than or equal to 0, and an absolute value of A may be greater than an absolute value of B. A battery cell having the first moving average being B may be diagnosed as an abnormal battery cell when the first low-voltage period is greater than or equal to M. A battery cell having the first moving average being at least A but not more than B may be diagnosed as an abnormal battery cell in case of designated threshold dates or more. Herein, the designated threshold date may be an y-axis value on a straight line based on coordinates (A, N) and (B, M) of the first low-voltage period with respect to the first moving average. A, B, N, and M may be random values. For example, For A of - 20, B of - 7, N of 10, and M of 100, a battery cell having the first moving average of - 7 mV may be diagnosed as an abnormal battery cell when the first low-voltage period is 100 days or more, and a battery cell having the first moving average of - 20 mV or less may be diagnosed as an abnormal battery cell regardless of the first low-voltage period.

Referring to FIGS. 7 and 8, the battery diagnosis apparatus 100 may diagnose the second battery cell 112 as an abnormal battery cell when the first low-voltage period with respect to the first moving average of the second battery cell 112 falls within the threshold range 800. On the other hand, the battery diagnosis apparatus 100 may diagnose the first battery cell 111 and the third battery cell 113 as normal battery cells when the first low-voltage period of each of the first battery cell 111 and the third battery cell 113 with respect to the first moving average does not fall within the threshold range 800.

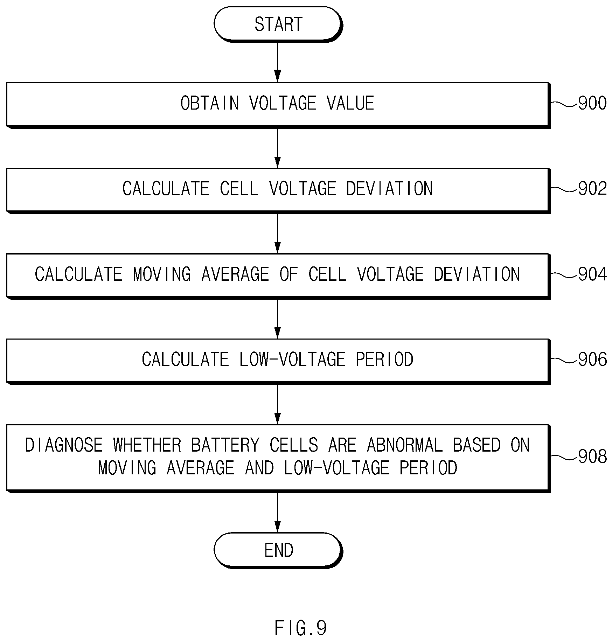

FIG. 9 is a flowchart showing an operating method of a battery diagnosis apparatus according to an embodiment disclosed herein.

Referring to FIG. 9, in operation 900, the battery diagnosis apparatus 100 may obtain a voltage value of each of the battery cells 111, 112, and 113.

In operation 902, the battery diagnosis apparatus 100 may calculate a cell voltage deviation of each of the battery cells 111, 112, and 113. The battery diagnosis apparatus 100 may calculate a cell voltage deviation of each of the battery cells 111, 112, and 113 based on the voltage value of each of the battery cells 111, 112, and 113 and the average voltage value of the battery cells 111, 112, and 113. Herein, the average voltage value may be an average of voltage values of all the battery cells or an average of voltage values for each battery module.

In operation 904, the battery diagnosis apparatus 100 may calculate a moving average of a cell voltage deviation.

In operation 906, the battery diagnosis apparatus 100 may calculate a low-voltage period based on a moving average.

In operation 908, the battery diagnosis apparatus 100 may diagnose whether the battery cells 111, 112, and 113 are abnormal, based on the moving average and the low-voltage period.

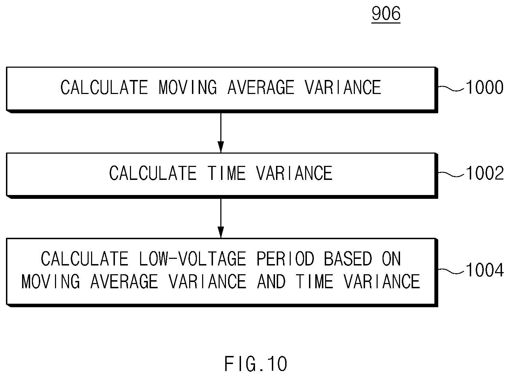

FIG. 10 is a flowchart showing a detailed operating method of operation 906 according to an embodiment disclosed herein.

Referring to FIG. 10, operation 906 shown in FIG. 9 may include operations 1000, 1002, and 1004.

In operation 1000, the battery diagnosis apparatus 100 may calculate a moving average variance. The battery diagnosis apparatus 100 may calculate the moving average variance based on a first moving average at the current time point and a second moving average at the previous time point. The battery diagnosis apparatus 100 may calculate the moving average variance based on a difference between the first moving average and the second moving average.

In operation 1002, the battery diagnosis apparatus 100 may calculate a time variance. The battery diagnosis apparatus 100 may calculate the time variance based on a time point corresponding to the first cell voltage deviation and a time point corresponding to the second cell voltage deviation. The battery diagnosis apparatus 100 may calculate a time variance based on a difference between the time point corresponding to the first cell voltage deviation and the time point corresponding to the second cell voltage deviation.

In operation 1004, the battery diagnosis apparatus 100 may calculate a low-voltage period based on a moving average variance and the time variance. The battery diagnosis apparatus 100 may calculate a first low-voltage period based on the moving average variance, the time variance, and a second low-voltage period calculated at the previous time point.

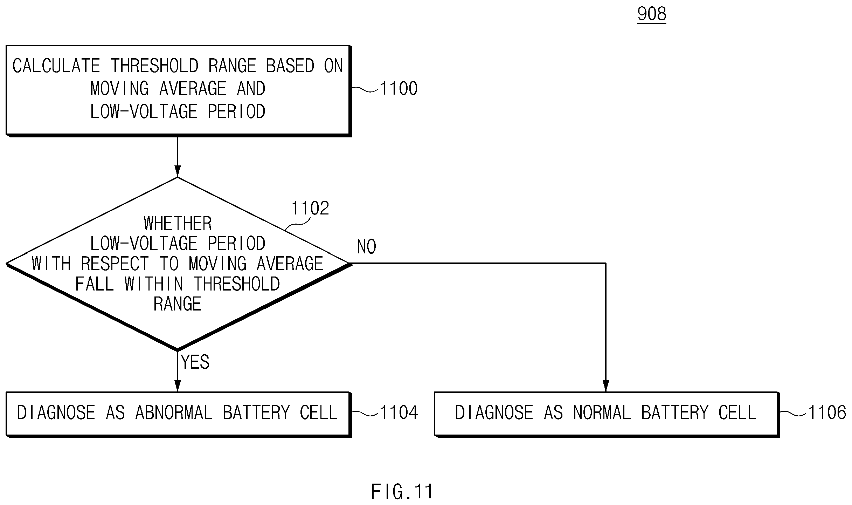

FIG. 11 is a flowchart showing a detailed operating method of operation 908 according to an embodiment disclosed herein.

Referring to FIG. 11, operation 908 shown in FIG. 9 may include operations 1100, 1102, 1104, and 1106.

In operation 1100, the battery diagnosis apparatus 100 may calculate the threshold range 800 based on the moving average and the low-voltage period. The battery diagnosis apparatus 100 may calculate the threshold range 800 based on a threshold value for the moving average and a threshold value for the low-voltage period. For example, the battery diagnosis apparatus 100 may calculate the threshold value for the moving average based on the moving average of each of the battery cells 111, 112, and 113, and calculate the threshold value for the low-voltage period based on the low-voltage period of each of the battery cells 111, 112, and 113.

In operation 1102, the battery diagnosis apparatus 100 may determine whether the low-voltage period with respect to the moving average falls within the threshold range 800. The battery diagnosis apparatus 100 may determine whether a value corresponding to the low-voltage period with respect to the first moving average falls within the threshold range 800.

In operation 1104, the battery diagnosis apparatus 100 may diagnose, as the abnormal battery cell, a battery cell in which the low-voltage period with respect to the moving average falls within the threshold range 800. The battery diagnosis apparatus 100 may diagnose, as the abnormal battery cell, a battery cell in which the low-voltage period with respect to the first moving average falls within the threshold range 800.

In operation 1106, the battery diagnosis apparatus 100 may diagnose, as an abnormal battery cell, a battery cell in which the low-voltage period corresponding to the moving average does not fall within the threshold range 800. The battery diagnosis apparatus 100 may diagnose, as an abnormal battery cell, a battery cell in which the first low-voltage period corresponding to the first moving average does not fall within the threshold range 800.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

**Claims**

1. A battery diagnosis apparatus comprising:

   a sensor configured to obtain a voltage value of each of battery cells; and
   a processor configured to:

   calculate a cell voltage deviation of each of the battery cells based on the voltage value and an average voltage value of the battery cells;
   calculate a moving average of the cell voltage deviation based on the cell voltage deviation;
   calculate a low-voltage period based on the moving average; and
   diagnose whether the battery cells are abnormal, based on the moving average and the low-voltage period.

2. The battery diagnosis apparatus of claim 1, wherein the cell voltage deviation comprises a first cell voltage deviation that is a cell voltage deviation at a current time point and a second cell voltage deviation that is a cell voltage deviation at a previous time point, and
   the moving average comprises a first moving average that is a moving average of the cell voltage deviation at the current time point and a second moving average that is a moving average of the cell voltage deviation at the previous time point.

3. The battery diagnosis apparatus of claim 2, wherein the processor is further configured to calculate the first moving average based on the first cell voltage deviation and the second moving average.

4. The battery diagnosis apparatus of claim 2, wherein the processor is further configured to:

   calculate a moving average variance based on a difference between the first moving average and the second moving average;
   calculate a time variance between a time point corresponding to the first cell voltage deviation and a time point corresponding to the second cell voltage deviation; and
   calculate the low-voltage period based on the moving average variance and the time variance.

5. The battery diagnosis apparatus of claim 4, wherein the processor is further configured to calculate the low-voltage period based on a result of comparison between the moving average variance and a reference value.

6. The battery diagnosis apparatus of claim 5, wherein the low-voltage period comprises a first low-voltage period that is the low-voltage period at the current time point and a second low-voltage period that is the low-voltage period at the previous time point.

7. The battery diagnosis apparatus of claim 6, wherein the processor is further configured to calculate the first low-voltage period by adding the time variance to the second low-voltage period when the moving average variance is greater than or equal to the reference value.

8. The battery diagnosis apparatus of claim 6, wherein the processor is further configured to calculate the first low-voltage period by subtracting the time variance from the second low-voltage period when the moving average variance is less than the reference value.

9. The battery diagnosis apparatus of claim 1, wherein the processor is further configured to:

   calculate a threshold range based on the moving average and the low-voltage period; and
   diagnose, as an abnormal battery cell, a battery cell in which the low-voltage period with respect to the moving average falls within the threshold range.

10. The battery diagnosis apparatus of claim 1, wherein the average voltage value is an average of voltage values for each battery module comprising the battery cells.

11. An operating method of a battery diagnosis apparatus, the operating method comprising:

    obtaining a voltage value of each of battery cells;

calculating a cell voltage deviation of each of the battery cells based on the voltage value and an average voltage value of the battery cells;
calculating a moving average of the cell voltage deviation based on the cell voltage deviation;
calculating a low-voltage period based on the moving average; and
diagnosing whether the battery cells are abnormal, based on the moving average and the low-voltage period.

12. The operating method of claim 11, wherein the cell voltage deviation comprises a first cell voltage deviation that is a cell voltage deviation at a current time point and a second cell voltage deviation that is a cell voltage deviation at a previous time point, and
the moving average comprises a first moving average that is a moving average of the cell voltage deviation at the current time point and a second moving average that is a moving average of the cell voltage deviation at the previous time point.

13. The operating method of claim 12, wherein

the calculating of the moving average comprises
calculating the first moving average based on the first cell voltage deviation and the second moving average.

14. The operating method of claim 12, wherein the calculating of the low-voltage period comprises:

calculating a moving average variance based on a difference between the first moving average and the second moving average;
calculating a time variance between a time point corresponding to the first cell voltage deviation and a time point corresponding to the second cell voltage deviation; and
calculating the low-voltage period based on the moving average variance and the time variance.

15. The operating method of claim 14, wherein the calculating of the low-voltage period comprises calculating the low-voltage period based on a result of comparison between the moving average variance and a reference value.

16. The operating method of claim 15, wherein the low-voltage period comprises a first low-voltage period that is the low-voltage period at the current time point and a second low-voltage period that is the low-voltage period at the previous time point.

17. The operating method of claim 16, wherein the calculating of the low-voltage period comprises calculating the first low-voltage period by adding the time variance to the second low-voltage period when the moving average variance is greater than or equal to the reference value.

18. The operating method of claim 16, wherein the calculating of the low-voltage period comprises calculating the first low-voltage period by subtracting the time variance from the second low-voltage period when the moving average variance is less than the reference value.

19. The operating method of claim 11, wherein the diagnosing comprises:

calculating a threshold range based on the moving average and the low-voltage period; and
diagnosing, as an abnormal battery cell, a battery cell in which the low-voltage period with respect to the moving average falls within the threshold range.

20. The operating method of claim 11, wherein the average voltage value is an average of voltage values for each battery module comprising the battery cells.

BATTERY PACK
1

FIRST BATTERY MODULE
11

FIRST BATTERY CELL
111

SECOND BATTERY CELL
112

THIRD BATTERY CELL
113

BATTERY
DIAGNOSIS
APPARATUS
100

SECOND BATTERY MODULE
12

THIRD BATTERY MODULE
13

FIG.1

100

```
┌──────────────────┐   ┌──────────────────────────┐
│     MEMORY       │   │  COMMUNICATION CIRCUIT   │
│      104         │   │           108            │
└──────────────────┘   └──────────────────────────┘
         │                          │
─────────┼──────────────┬───────────┼──────────────
         │              │
┌──────────────────┐   ┌──────────────────┐
│     SENSOR       │   │    PROCESSOR     │
│      102         │   │      106         │
└──────────────────┘   └──────────────────┘
```

FIG.2

ELECTRONIC DEVICE
30

BATTERY PACK
1

⟺

BATTERY
DIAGNOSIS
APPARATUS
100

⟺

USER TERMINAL
300

FIG.3

FIG.4

FIG.5

FIG.6

FIG.7

FIG.8

START

OBTAIN VOLTAGE VALUE ~900

CALCULATE CELL VOLTAGE DEVIATION ~902

CALCULATE MOVING AVERAGE OF CELL VOLTAGE DEVIATION ~904

CALCULATE LOW-VOLTAGE PERIOD ~906

DIAGNOSE WHETHER BATTERY CELLS ARE ABNORMAL BASED ON MOVING AVERAGE AND LOW-VOLTAGE PERIOD ~908

END

FIG.9

906

```
┌─────────────────────────────────────────┐
│    CALCULATE MOVING AVERAGE VARIANCE     │∽1000
└─────────────────────────────────────────┘
                    │
                    ▼
┌─────────────────────────────────────────┐
│         CALCULATE TIME VARIANCE          │∽1002
└─────────────────────────────────────────┘
                    │
                    ▼
┌─────────────────────────────────────────┐
│   CALCULATE LOW-VOLTAGE PERIOD BASED ON  │∽1004
│  MOVING AVERAGE VARIANCE AND TIME VARIANCE│
└─────────────────────────────────────────┘
```

FIG.10

908

FIG.11

## INTERNATIONAL SEARCH REPORT

| International application No. |
|---|
| **PCT/KR2024/012584** |

| A. | CLASSIFICATION OF SUBJECT MATTER |
|---|---|

**G01R 31/392**(2019.01)i; **G01R 31/385**(2019.01)i; **G01R 31/367**(2019.01)i; **G01R 19/10**(2006.01)i; **G01R 19/00**(2006.01)i

According to International Patent Classification (IPC) or to both national classification and IPC

| B. | FIELDS SEARCHED |
|---|---|

Minimum documentation searched (classification system followed by classification symbols)

G01R 31/392(2019.01); G01R 19/00(2006.01); G01R 31/36(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 이동 평균(moving average), 편차(deviation), 저전압(low voltage)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2022-0074797 A (LG ENERGY SOLUTION, LTD.) 03 June 2022 (2022-06-03)<br>See paragraphs [0051]-[0052], claims 1-8 and figure 1. | 1-20 |
| Y | KR 10-2020-0039215 A (LG CHEM, LTD.) 16 April 2020 (2020-04-16)<br>See claims 1-2. | 1-20 |
| A | KR 10-2022-0146255 A (LG ENERGY SOLUTION, LTD.) 01 November 2022 (2022-11-01)<br>See paragraphs [0034]-[0074]. | 1-20 |
| A | KR 10-2022-0025416 A (LG ENERGY SOLUTION, LTD.) 03 March 2022 (2022-03-03)<br>See claims 1-6 and figure 5. | 1-20 |
| A | JP 2013-220011 A (YAMAHA MOTOR CO., LTD.) 24 October 2013 (2013-10-24)<br>See paragraphs [0046]-[0063]. | 1-20 |

| ☐ Further documents are listed in the continuation of Box C. | ☑ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **27 November 2024** | **27 November 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/012584**

| Patent document cited in search report | | | Publication date (day/month/year) | Patent family member(s) | | | Publication date (day/month/year) |
|---|---|---|---|---|---|---|---|
| KR | 10-2022-0074797 | A | 03 June 2022 | CN | 115461634 | A | 09 December 2022 |
| | | | | EP | 4152021 | A1 | 22 March 2023 |
| | | | | EP | 4152021 | A4 | 03 January 2024 |
| | | | | JP | 2023-519949 | A | 15 May 2023 |
| | | | | JP | 2024-099795 | A | 25 July 2024 |
| | | | | JP | 7483922 | B2 | 15 May 2024 |
| | | | | KR | 10-2024-0109971 | A | 12 July 2024 |
| | | | | KR | 10-2684286 | B1 | 11 July 2024 |
| | | | | US | 11768251 | B2 | 26 September 2023 |
| | | | | US | 2023-0152388 | A1 | 18 May 2023 |
| | | | | US | 2023-0243895 | A1 | 03 August 2023 |
| | | | | WO | 2022-114871 | A1 | 02 June 2022 |
| KR | 10-2020-0039215 | A | 16 April 2020 | CN | 112888954 | A | 01 June 2021 |
| | | | | CN | 112888954 | B | 10 May 2024 |
| | | | | EP | 3859363 | A1 | 04 August 2021 |
| | | | | EP | 3859363 | A4 | 08 December 2021 |
| | | | | EP | 3859363 | B1 | 31 July 2024 |
| | | | | KR | 10-2391533 | B1 | 28 April 2022 |
| | | | | US | 11940501 | B2 | 26 March 2024 |
| | | | | US | 2022-0043068 | A1 | 10 February 2022 |
| | | | | WO | 2020-071848 | A1 | 09 April 2020 |
| KR | 10-2022-0146255 | A | 01 November 2022 | None | | | |
| KR | 10-2022-0025416 | A | 03 March 2022 | None | | | |
| JP | 2013-220011 | A | 24 October 2013 | CN | 103376351 | A | 30 October 2013 |
| | | | | EP | 2650165 | A2 | 16 October 2013 |
| | | | | EP | 2650165 | A3 | 16 April 2014 |

Form PCT/ISA/210 (patent family annex) (July 2022)

**EP 4 749 307 A1**

**Patent documents cited in the description**

- KR 1020230122554